Europäisches Patentamt

European Patent Office

Office européen des brevets

(11) Numéro de publication: **0 174 545**
**A1**

## (12) DEMANDE DE BREVET EUROPEEN

(21) Numéro de dépôt: 85110707.8

(22) Date de dépôt: 27.08.85

(51) Int. Cl.⁴: **H 05 K 13/04**
**H 05 K 13/08**

(30) Priorité: 30.08.84 FR 8413444

(43) Date de publication de la demande:
**19.03.86 Bulletin 86/12**

(84) Etats contractants désignés:
**BE CH DE FR GB IT LI NL SE**

(71) Demandeur: **COMPAGNIE INDUSTRIELLE DES
TELECOMMUNICATIONS CIT-ALCATEL S.A. dite:
12, rue de la Baume
F-75008 Paris(FR)**

(72) Inventeur: **Le Guillerm, Jean
La Sapinière
F-22420 Plouaret(FR)**

(74) Mandataire: **Weinmiller, Jürgen et al,
Zeppelinstrasse 63
D-8000 München 80(DE)**

(54) Atelier flexible de fabrication d'ensembles mécaniques et/ou électriques.

(57) Un atelier flexible comporte un magasin et des îlots (L1 à Ln) constitués par des postes de travail, automatiques ou manuels. Le magasin est constitué par au moins un rayonnage (R) et au moins un transtockeur (T). Des chargeurs (C) contenant un ou plusieurs éléments de base des ensembles sont contenus dans des alvéoles A) du rayonnage. Un calculateur central (CC) commande le (s) transtockeur (s) et est en liaison avec les postes de travail. Chaque îlot (L1 à Ln) est associé à un poste d'entrée/sortie (CD1 à CDn) des chargeurs. Un chargeur est sorti du rayonnage et déposé sur un poste d'entrée/sortie par le transtockeur ; réciproquement un chargeur libéré par un îlot est repris par le transtockeur au poste d'entrée/sortie associé à l'îlot, et rangé dans le rayonnage.

L'atelier flexible peut comporter plusieurs niveaux, le magasin étant commun aux niveaux.

FIG.1

EP 0 174 545 A1

Atelier flexible de fabrication d'ensembles mécaniques et/ou électriques.

L'invention concerne un atelier flexible de fabrication d'ensembles mécaniques et/ou électriques dans lequel on effectue des opérations d'usinage et ou de montage de pièces entrant dans la constitution des ensembles.

Un ensemble désigne des produits très variés, tels que par exemple moteurs à essence ou diésel, contacteurs électriques, cartes de circuits imprimés, moteurs électriques et d'une manière générale tout produit faisant l'objet d'une fabrication en série.

La fabrication peut se faire à la chaîne, solution bien connue pour des produits fabriqués en très grande série, mais qui par sa rigidité est mal adaptée à la fabrication de variantes de produits, et nécessite souvent des stocks intermédiaires pour éviter le blocage de la chaîne ; par ailleurs une telle chaîne est difficilement modifiable.

Il existe également des ateliers flexibles avec magasin déporté, qui nécessitent beaucoup de convoyeurs pour aller aux postes de travail. Ce type de magasin comporte généralement un transtockeur par allée, de sorte qu'en cas de panne d'un transtockeur les pièces stockées dans l'allée correspondante sont bloquées. De plus l'automatisation des transtockeurs et des convoyeurs est très onéreuse, principalement du fait de leur nombre.

Une autre solution utilisée est le stockage centralisé, les postes de travail étant desservis par chariots filoguidés ; ce type de solution est complexe à gérer et nécessite beaucoup de surface au sol.

La présente invention a pour but de remédier aux inconvénients des solutions connues, et de donner à l'atelier flexible la souplesse nécessaire pour la fabrication de plusieurs types d'une gamme d'ensembles, comme par exemple différents types de moteurs, de cartes de circuits imprimés, de contacteurs, etc....

La présente invention a pour objet un atelier flexible de fabrication d'ensembles mécaniques et/ou électriques, notamment de cartes de circuits imprimés, un ensemble comportant un élément de base et des pièces ou des composants montés sur ledit élément de base, ledit atelier effectuant des opérations d'usinage et/ou de montage et comportant un magasin où lesdits éléments de base sont stockés, des postes de travail alimentés en éléments de base à partir du magasin, et un calculateur central pour piloter le magasin et l'acheminement des éléments de base vers les postes de travail, caractérisé par le fait que le magasin comporte au moins un rayonnage ayant deux faces longitudinales dont l'une au moins est ouverte, et au moins un transtockeur, un transtockeur se déplaçant le long d'une face longitudinale ouverte, que ledit rayonnage est constitué par des alvéoles disposées en lignes et en colonnes, que des chargeurs sont rangés dans les alvéoles à raison d'un chargeur par alvéole, chaque chargeur ayant un code d'identification, que des îlots constitués chacun par au moins un poste de travail sont disposés en regard d'au moins une desdites faces longitudinales, chaque îlot étant associé à un poste d'entrée/sortie des chargeurs qui reçoit les chargeurs sortis du magasin par le transtockeur et destinés à l'îlot, et les chargeurs libérés par l'îlot pour être rangés par le transtockeur dans le magasin, que les chargeurs rangés dans les alvéoles sont des chargeurs contenant chacun au moins un élément de base, lesdits chargeurs attendant d'être sortis pour la première fois du magasin, et des chargeurs libérés par un îlot quelconque et contenant chacun ledit élément de base après passage sur ledit îlot quelconque, qu'un transtockeur comporte des moyens de pilotage commandés par le calculateur central, et que les postes de travail des îlots comportent des moyens pour informer le calculateur central de la libération d'un chargeur, ledit calculateur central commandant les entrées et les sorties des chargeurs du rayonnage et leur passage d'un îlot à un autre selon une gamme opératoire.

L'invention va être décrite à l'aide d'exemples de réalisations illustrés par les figures annexées dans lesquelles :
- la figure 1 représente schématiquement un premier mode d'implantation au sol d'un atelier flexible de l'invention,
- la figure 2 représente schématiquement un deuxième mode d'implantation au sol d'un atelier flexible de l'invention,
- la figure 3 représente schématiquement un troisième mode d'implantation au sol d'un atelier flexible de l'invention,
- la figure 4 représente schématiquement un quatrième mode d'implantation au sol d'un atelier flexible de l'invention,
- la figure 5 représente schématiquement un cinquième mode d'implantation au sol d'un atelier flexible de l'invention,
- la figure 6 représente schématiquement un sixième mode d'implantation au sol d'un atelier flexible de l'invention,

- la figure 7 représente schématiquement en élévation un septième mode d'implantation d'un atelier flexible de l'invention,

- la figure 8 représente schématiquement, en élévation un huitième mode d'implantation d'un atelier flexible de l'invention,

- la figure 9 est une vue de face, d'un rayonnage de l'atelier flexible de l'invention,

- la figure 10 est une représentation schématique de deux types d'îlots faisant partie de l'atelier flexible des figures 1 à 6.

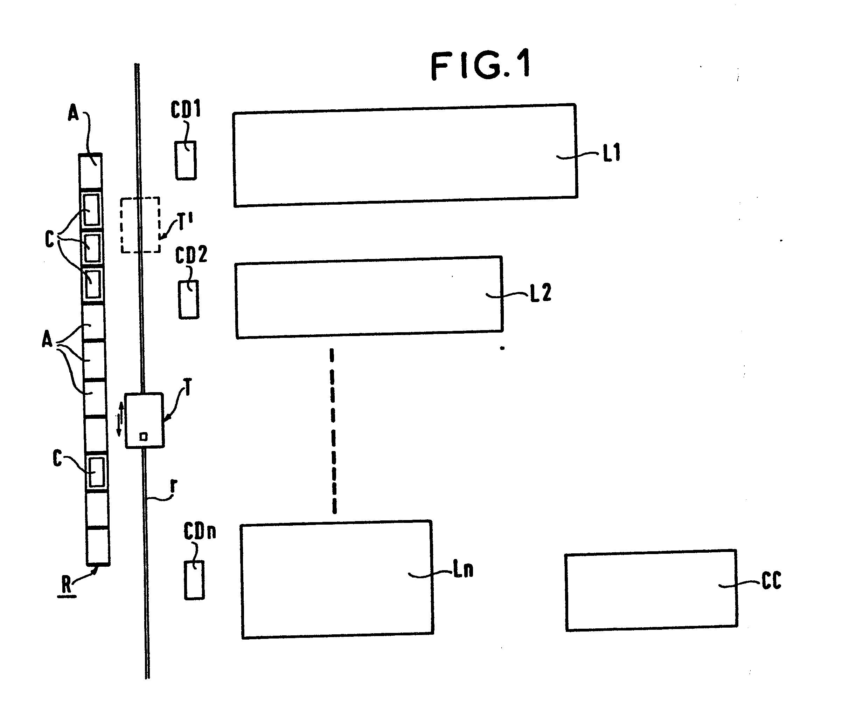

Dans la figure 1, qui représente un premier mode d'implantation d'un atelier flexible de l'invention, L1 à Ln sont des îlots comportant chacun un ou plusieurs postes de travail, T est un dispositif de manutention que l'on appelera dans la suite de la description transtockeur, R est un rayonnage, et CC un calculateur central. L'ensemble rayonnage R et transtockeur T constitue le magasin de l'atelier flexible.

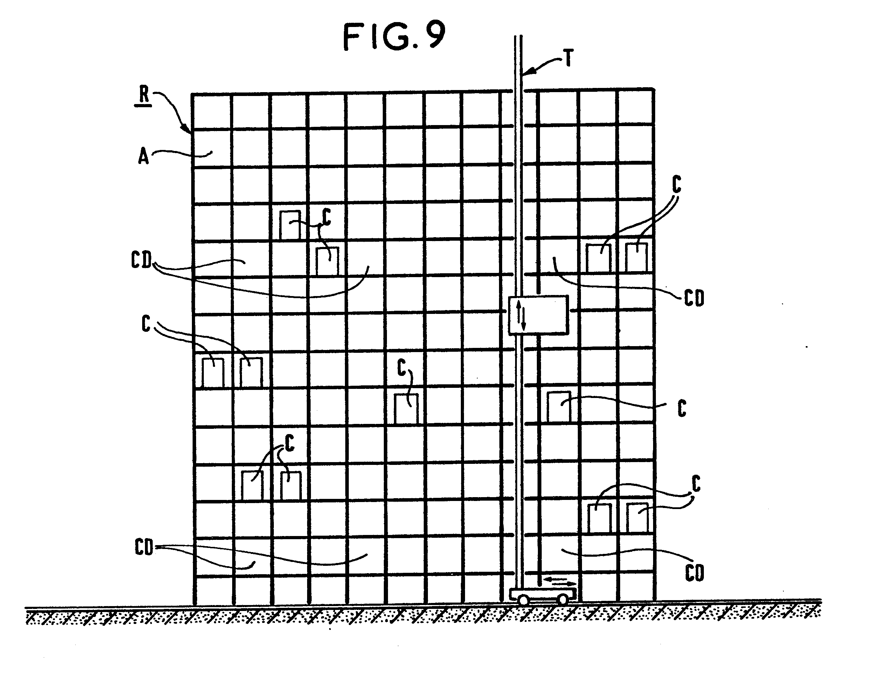

Le rayonnage R est divisé en alvéoles A selon des lignes et des colonnes comme illustré figure 9 qui est une vue de face du rayonnage R, ouvert sur au moins une de ses faces longitudinales ; chaque alvéole peut recevoir un chargeur C. Un ensemble fabriqué par l'atelier flexible comporte un élément de base et des pièces, ou des composants montés sur ledit élément de base, l'atelier effectuant des opérations d'usinage et/ou de montage aux divers postes de travail. Un chargeur contient donc un ou plusieurs éléments de base, et sera acheminé vers les îlots selon une gamme opératoire et sous commande du calculateur central.

Le transtockeur T est un dispositif de manutention de tout type connu se déplaçant le long du rayonnage R, par exemple sur un rail r. Le transtockeur comporte un mât vertical fixé à un châssis qui se déplace sur le rail r, et un système de manutention mobile le long du mât grâce à un système de câbles et de poulies, ou de chaînes et de pignons. Le système de manutention comporte un dispositif de prise des chargeurs C, par exemple une fourche télescopique ou un système de chaînes comportant des ergots.

Les déplacements du transtockeur sur le rail, du système de manutention le long du mât, et du dispositif de prise sont commandés par des moteurs asservis en position et en vitesse, le transtockeur comportant, pour son pilotage, un automate, ou une carte à base de microprocesseurs, relié au calculateur central CC par une liaison de tout type connu, par exemple boucle de courant, lignes asynchrones du type RS 232C ou RS 422.

Les chargeurs C comportent chacun un code d'identification et le transtockeur est muni d'un lecteur de code ; lors de toute manutention d'un chargeur le code de ce chargeur est lu par le transtockeur et transmis au calculateur central CC.

Des postes d'entrée/sortie, CD1 à CDn, des chargeurs C sont associés à chaque îlot L1 à Ln. Lorsque, sur ordre du calculateur central le transtockeur T sort un chargeur C du rayonnage R à destination d'un îlot Li, il dépose le chargeur au poste d'entrée/sortie CD associé à l'îlot Li. Lorsque sur ordre du calculateur central le transtockeur doit rentrer un chargeur dans le rayonnage R, il prend le chargeur au poste d'entrée/sortie CDj qui lui est indiqué par le calculateur.

Un chargeur C est acheminé depuis un poste d'entrée/sortie CDi vers un poste de travail de l'îlot Li, et réciproquement, soit par un convoyeur, soit par des chariots filoguidés par exemple.

Pour augmenter le débit du magasin il est possible d'utiliser un deuxième transtockeur T' qui se déplace également sur le rail r. Chaque transtockeur dessert une partie du rayonnage qui lui est attribuée en propre, ainsi qu'une partie du rayonnage, appelé zone commune dans laquelle il peut y avoir conflit entre les transtockeurs ; les transtockeurs sont commandés par le calculateur central CC qui règle les conflits pouvant survenir.

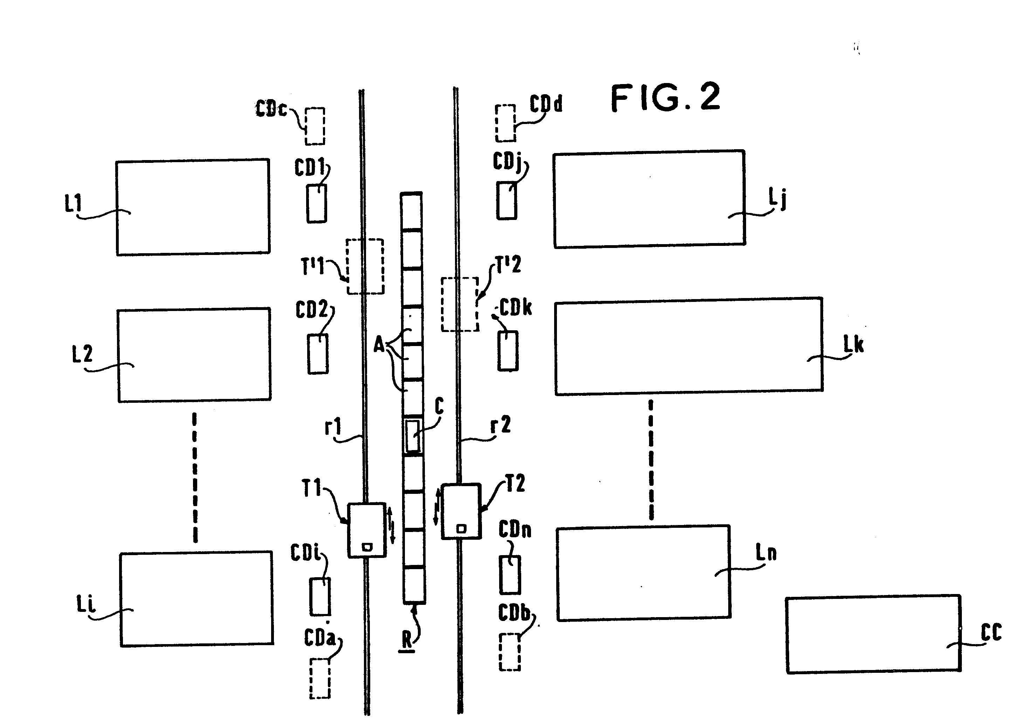

Dans l'exemple de la figure 1, les îlots L1 à Ln sont disposés d'un même côté du magasin constitué par le rayonnage R et le transtockeur T. Afin d'augmenter les transferts entre le magasin et les îlots, ou lorsque l'on désire augmenter le nombre d'îlots, il est possible de répartir les îlots de chaque côté du magasin, comme représenté figure 2. Dans cette figure le magasin est constitué par le rayonnage R, ouvert sur ses deux faces longitudinales, et deux transtockeurs T1 et T2, un de chaque côté du rayonnage ; les transtockeurs se déplacent le long du rayonnage sur des rails r1, r2. En regard d'une face longitudinale du rayonnage des îlots L1 à Li sont associés à des postes d'entrée/sortie CD1 à CDi, et en regard de l'autre face longitudinale du rayonnage,

des îlots Lj à Ln sont associés à des postes d'entrée/sortie CDj à CDn ; le transtockeur T1 dessert les postes d'entrée/sortie CD1 à CDi, et le transtockeur T2 dessert les postes d'entrée/sortie CDj à CDn. Un chargeur C quelconque présent dans le rayonnage R peut être sorti par l'un ou l'autre des transtockeurs T1 et T2. Comme dans l'exemple de la figure 1 un chargeur pris dans le rayonnage R est déposé au poste d'entrée/sortie de l'îlot associé et inversement. Un chargeur C peut donc après être passé dans un ou plusieurs îlots desservis par un transtockeur être acheminé vers un îlot desservi par l'autre transtockeur dès lors qu'il est dans une alvéole A du rayonnage R ; bien entendu les entrées et sorties des chargeurs dans le rayonnage se font sous commande du calculateur central.

Dans l'exemple illustré par la figure 2 il est possible en cas de panne d'un transtockeur de sortir les chargeurs du rayonnage R par l'autre transtockeur, ce qui permet de ne pas interrompre le fonctionnement de l'atelier flexible. A cet effet deux postes d'entrée/sortie auxiliaires CDa et CDb sont prévus, un pour chaque transtockeur. En cas de panne du transtockeur T2, le transtockeur T1 sort du rayonnage R les chargeurs destinés aux îlots Lj à Ln et les dépose au poste d'entrée/sortie auxiliaire CDa d'où ils sont acheminés manuellement vers les postes d'entrée/sortie CDj à CDn ; de même les rentrées en rayonnage se font en acheminant manuellement les chargeurs des postes d'entrée/sortie CDj à CDn au poste d'entrée/sortie auxiliaire CDa. En cas de panne du transtockeur T1, le transtockeur T2 sort les chargeurs du rayonnage R et les dépose au poste d'entrée/sortie auxiliaire CDb, et y prend les chargeurs à rentrer dans le rayonnage.

Dans l'exemple illustré par la figure 2 il est possible de prévoir deux transtockeurs T1 et T'1 d'un côté du rayonnage et deux transtockeurs T2 et T'2 de l'autre côté. Dans ce cas il est également possible de prévoir deux autres postes d'entrée/sortie auxiliaires CDc et CDd, les postes d'entrée/sortie auxiliaires CDa et CDb sont alors desservis par les transtockeurs T1 et T2, réciproquement, les postes d'entrée/sortie auxiliaires CDc et CDd étant desservis par les transtockeurs T'1 et T'2, respectivement. En cas de panne du transtockeur T2, le transtockeur T1 assure pour la partie du rayonnage desservie par le transtockeur T2, les entrées et les sorties des chargeurs via le poste d'entrée/sortie auxiliaire CDa ; en cas de panne du transtockeur T'2 le transtockeur T'1 assure pour la partie du rayonnage desservie par le transtockeur T'2, les entrées et les sorties des chargeurs via le poste d'entrée/sortie auxiliaire CDc ; en cas de panne du transtockeur T1 le transtockeur T2 assure pour la partie du rayonnage desservie par le transtockeur T1, les entrées et les sorties des chargeurs via le poste d'entrée/sortie auxiliaire CDb ; en cas de panne du transtockeur T'1 le transtockeur T'2 assure pour la partie du rayonnage desservie par le transtockeur T'1, les entrées et les sorties des chargeurs via le poste d'entrée/sortie auxiliaire CDd. Bien entendu en cas de panne d'un transtockeur les autres transtockeurs restent en fonctionnement.

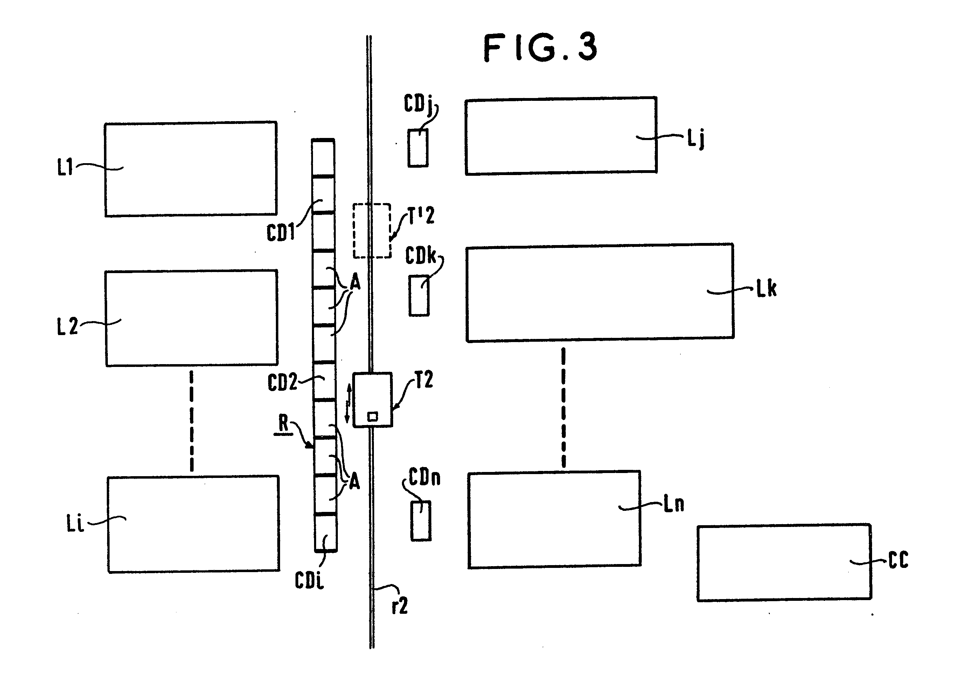

La figure 3 illustre un autre exemple d'implantation d'un atelier flexible de l'invention. Dans cette figure les îlots L1 à Ln sont disposés, comme dans la figure 2, en regard de chaque face longitudinale du rayonnage R, mais le rayonnage est desservi par un seul transtockeur T2, en reprenant les mêmes références que dans la figure 2. Dans cet exemple les îlots Lj à Ln sont associés à des postes d'entrée/sortie CDj à CDn, du même côté que les îlots par rapport au transtockeur T2, comme dans la figure 2 ; les îlots L1 à Li sont également associés à des postes d'entrée/sortie CD1 à CDi, mais ces postes d'entrée/sortie sont constitués chacun par une alvéole A du rayonnage R, et les chargeurs à destination ou en provenance de l'îlot associé sont acheminés par convoyeur ou par chariots filoguidés, comme dans le cas des postes d'entrée/sortie CDj à CDn associés aux îlots Lj à Ln. Le rayonnage R est ouvert au moins du côté du transtockeur T2 ; les alvéoles constituant les postes d'entrée/sortie CD1 à CDi sont ouverts sur chaque face longitudinale du rayonnage R, et constituent chacune un accès latéral du rayonnage R.

Le transtockeur T2 sort un chargeur C du rayonnage R à destination d'un îlot quelconque et le dépose au poste d'entrée/sortie associé à l'îlot destinataire, quel que soit ce poste d'entrée/sortie ; de même le transtockeur T2 reprend un chargeur à un poste d'entrée/sortie quelconque pour le ranger dans le rayonnage. Il est également possible, dans cet exemple d'utiliser deux transtockeurs T2 et T'2.

Dans l'exemple de la figure 3, le magasin comporte un rayonnage R

et un transstockeur T, comme dans l'exemple de la figure 1 ; par contre les îlots sont situés de part et d'autre des faces longitudinales du rayonnage R, alors que dans la figure 1 les îlots sont tous situés du même côté que le transstockeur. Compte tenu du fait que dans la figure 3 les postes d'entrée/sortie CD1 à CDi associés aux îlots L1 à Li sont constitués par des alvéoles du rayonnage R et que le transstockeur T dessert également les îlots L1 à Li, l'atelier flexible de l'invention peut n'avoir des îlots qu'en regard de la face longitudinale du rayonnage opposée à celle le long de laquelle se déplace le transstockeur T. Dans la figure 3 cela revient donc à n'avoir que les îlots L1 à Li, ce qui constitue une variante de l'exemple de la figure 1, cette variante permettant comme dans le cas de la figure 1 d'augmenter la capacité de l'atelier flexible en implantant des îlots de l'autre côté du rayonnage, ce qui donne l'implantation de la figure 3.

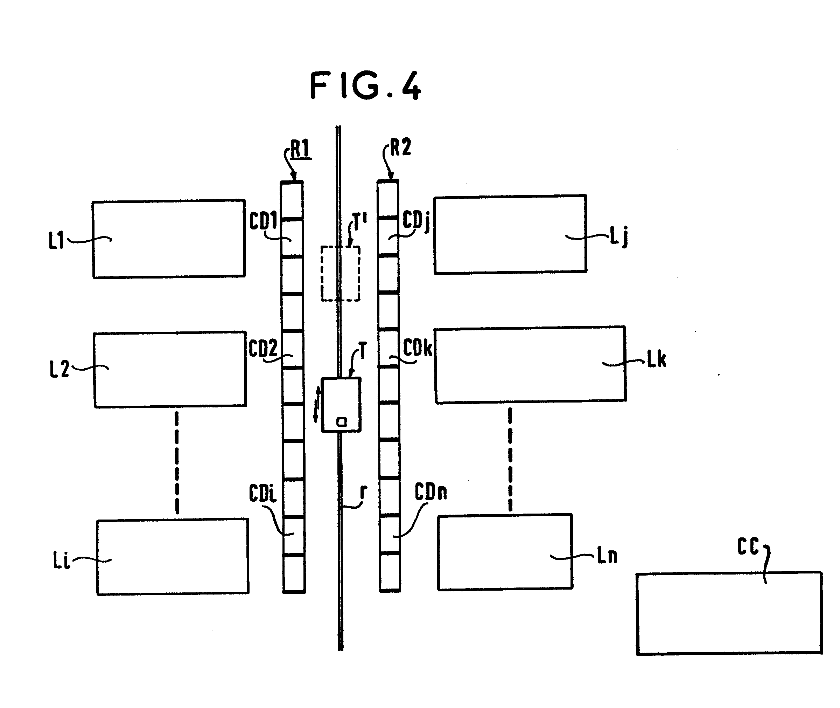

La figure 4 illustre un autre exemple d'implantation de l'atelier flexible de l'invention. Dans cette figure le magasin comporte deux rayonnages R1 et R2 et un transstockeur T qui se déplace sur le rail r entre les deux rayonnages. Les rayonnages sont chacun à accès latéral, les postes d'entrée/sortie CD1 à CDn étant constitués chacun par une alvéole des rayonnages. Il est également possible d'utiliser un deuxième transstockeur T' qui se déplace, comme le transstockeur T, sur le rail r ; les conflits entre les deux transstockeurs sont gérés par le calculateur central CC.

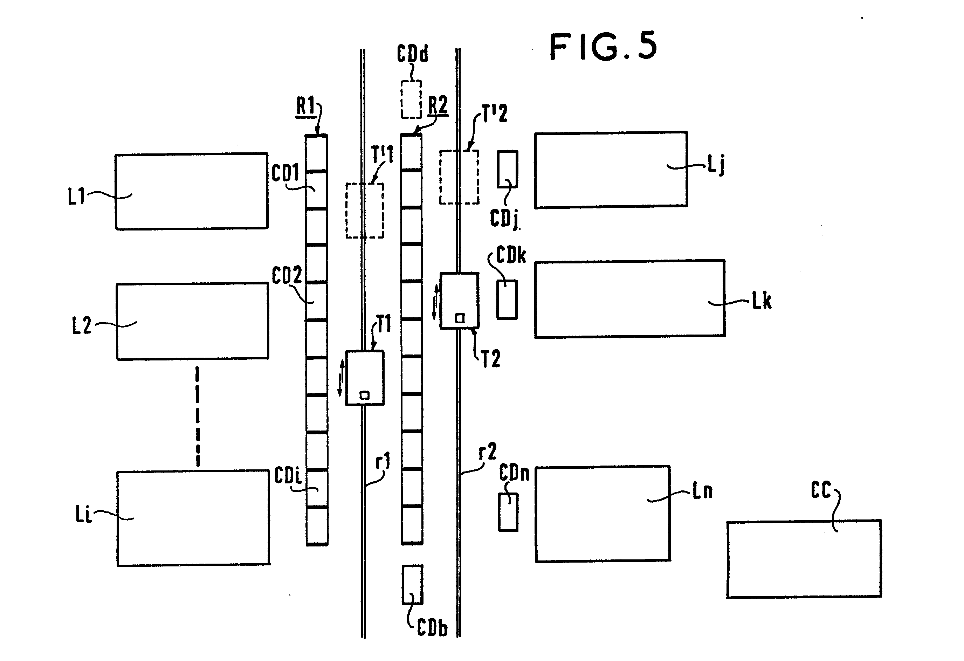

La figure 5 illustre un cinquième exemple d'implantation de l'atelier flexible de l'invention. Comme dans le cas de la figure 4 les îlots sont disposés de chaque côté du magasin qui comporte également deux rayonnages R1 et R2. A la différence de la figure 4, le magasin comporte deux transstockeurs T1 et T2, le transstockeur T1 se déplaçant sur un rail r1 entre les deux rayonnages, le transstockeur T2 se déplaçant sur un rail r2 et desservant les îlots Lj à Ln qui sont situés du même côté que lui du magasin. Le rayonnage R1 est à accès latéral, les postes d'entrée/sortie CD1 à CDi associés aux îlots L1 à Li étant constitués chacun par une alvéole du rayonnage R1. Le transstockeur T1 dépose aux postes d'entrée/sortie CD1 à CDi des chargeurs pris dans l'un quelconque des deux rayonnages R1 et R2 et reprend à ces mêmes postes d'entrée/sor- tie CD1 à CDi les chargeurs à ranger dans l'un ou l'autre des rayonnages R1 et R2, sur commande du calculateur central. Le transtockeur T2 assure les entrées et les sorties des chargeurs du rayonnage R2 à destination ou en provenances des îlots Lj à Ln, via les postes d'entrée/sortie CDj à CDn associés à chaque îlot, ces postes d'entrée/sortie étant en dehors du rayonnage R2, comme dans l'exemple de la figure 1 ; le rayonnage R2 est ouvert sur ses deux faces. Le transtockeur T1 assure également si nécessaire, les transferts des chargeurs entre les rayonnages R1 et R2, ces transferts étant commandés par le calculateur central CC. Un chargeur rentrant d'un des ilôts L1 à Li et devant pour l'opération suivante passer sur l'un des ilôts Lj à Ln devra impérativement être rangé par le transtockeur T1 sur le rayonnage R2 de façon à être accessible par le transtockeur T2, ceci afin d'éviter des transferts du rayonnage R1 au rayonnage R2 par T1. En cas de panne du transtockeur T2, le transtockeur T1 assure les entrées et les sorties des chargeurs rayonnages R2 via un poste d'entrée/sortie auxiliaire CDb, les chargeurs étant acheminés manuellement vers les postes d'entrée/sortie CDj à CDn, et réciproquement. Chaque rail r1 et r2 peut servir au déplacement de deux transtockeurs T1, T'1 et T2, T'2, les conflits entre deux transtockeurs étant réglés par le calculateur central CC. Dans le cas de deux transtockeurs par rail, le transtockeur T1 peut en cas de panne du transtockeur T2 assurer les entrées et les sorties des chargeurs du rayonnage R2 via le poste d'entrée/sortie auxiliaire CDb, et le transtockeur T'1 assurer les entrées et les sorties des chargeurs du rayonnage R2 via un autre poste d'entrée/sortie auxiliaire CDd.

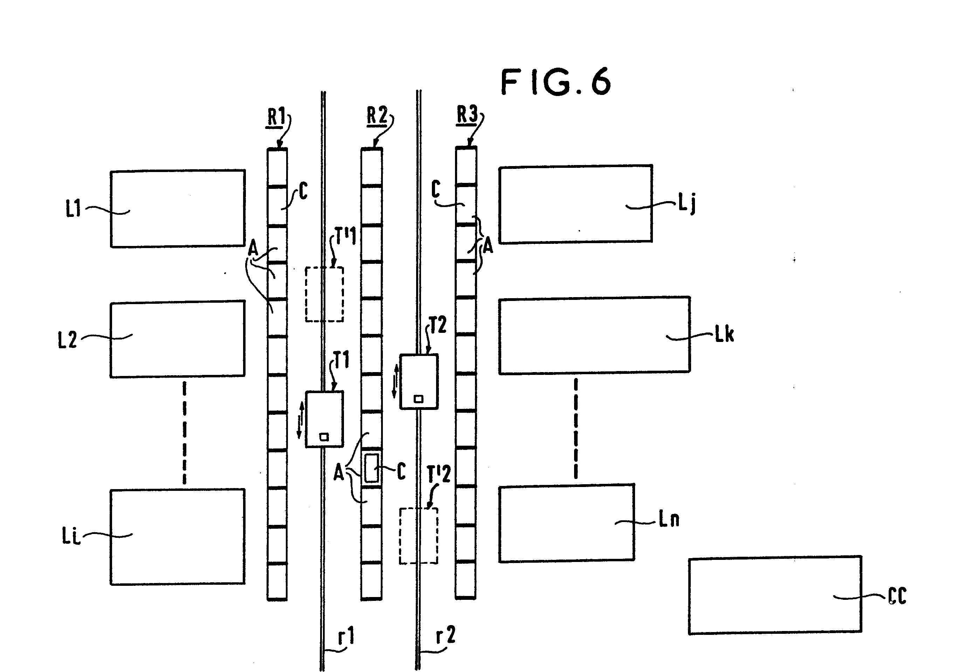

La figure 6 illustre un autre exemple d'implantation d'un atelier flexible de l'invention. Dans cette figure les îlots sont répartis de part et d'autre du magasin constitué par trois rayonnages R1, R2, R3 et deux transtockeurs T1 et T2 ; les rayonnages étant disposés parallèlement entre eux, le transtockeur T1 se déplace sur le rail r1 entre les rayonnages R1 et R2, et le transtockeur T2 se déplace sur le rail r2 entre les rayonnages R2 et R3. Le rayonnage R2, situé entre les rayonnages R1 et R3, est ouvert sur ses deux faces ; les rayonnages R1 et R3 sont à accès latéral, et ouverts au moins sur leur face en regard du rayonnage R2. Un chargeur devant passer d'un des ilôts L1 à Li à un des ilôts Lj à Ln ou réciproquement devant passer d'un des ilôts Lj à Ln à un des ilôts L1 à Li devra impérativement être rangé dans le rayonnage central R2 dont la particularité est que tout chargeur y est accessible par les deux transtockeurs T1 et T2. Il est également possible d'avoir un deuxième transtockeur T'1, T'2 sur chaque rail r1, r2.

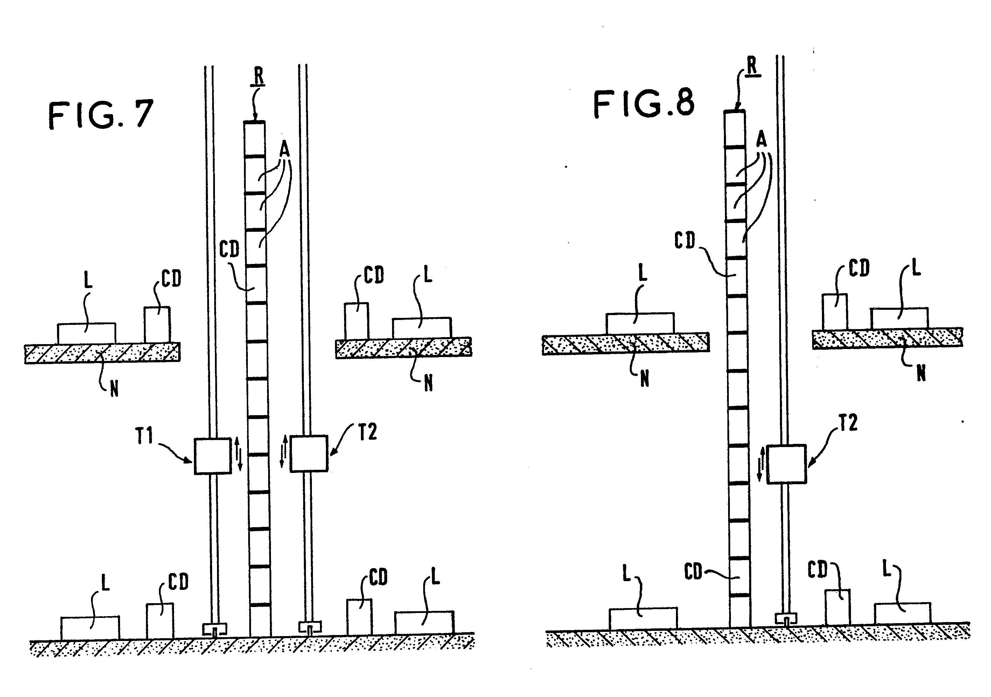

Les figures 7 et 8 représentent schématiquement, en élévation, un atelier flexible de l'invention, la figure 7 étant relative à la figure 2, et la figure 8 étant relative à la figure 3. Dans ces figures l'atelier flexible comporte un étage N ; le sol et l'étage N comportent des îlots L de part et d'autre du magasin dont le rayonnage R s'étend verticalement depuis le sol jusqu'au dessus de l'étage N. Le transtockeur T2, figure 8, et les transtockeurs T1 et T2, figure 7, se déplacent verticalement, le long de leur mât, sur toute la hauteur du rayonnage R et desservent les îlots du sol et de l'étage ; bien évidemment les transtockeurs se déplacent comme représenté figures 2 et 3, le long du rayonnage. Dans la figure 7 les îlots du sol et de l'étage sont associés chacun à un poste d'entrée/sortie CD ; dans la figure 8 les îlots du sol et de l'étage situés du côté du transtockeur T2 sont associés, comme dans la figure 3 à un poste d'entrée/sortie CD situé hors du magasin, et les îlots du sol et de l'étage situés de l'autre côté du rayonnage sont associés à des poste d'entrée/sortie constitués chacun par une alvéole A du rayonnage.

Bien entendu l'atelier flexible peut comporter plus d'un étage ; de même le magasin peut comporter deux ou trois rayonnages, comme cela est illustré par les figures 4 à 6.

La figure 9 représente un rayonnage R vu de face, et un transtockeur T. Le rayonnage comporte des alvéoles A disposées en lignes et en colonnes chaque alvéole pouvant recevoir un chargeur C. Dans cette figure on a désigné par CD des alvéoles qui sont utilisées comme postes d'entrée/sortie des chargeurs, lorsque le rayonnage est à accès latéral, comme indiqué figures 3, 4, 5, 6 ; cet alvéole, lorsque le rayonnage n'est pas à accès latéral est utilisé normalement comme les autres alvéoles pour stocker un chargeur.

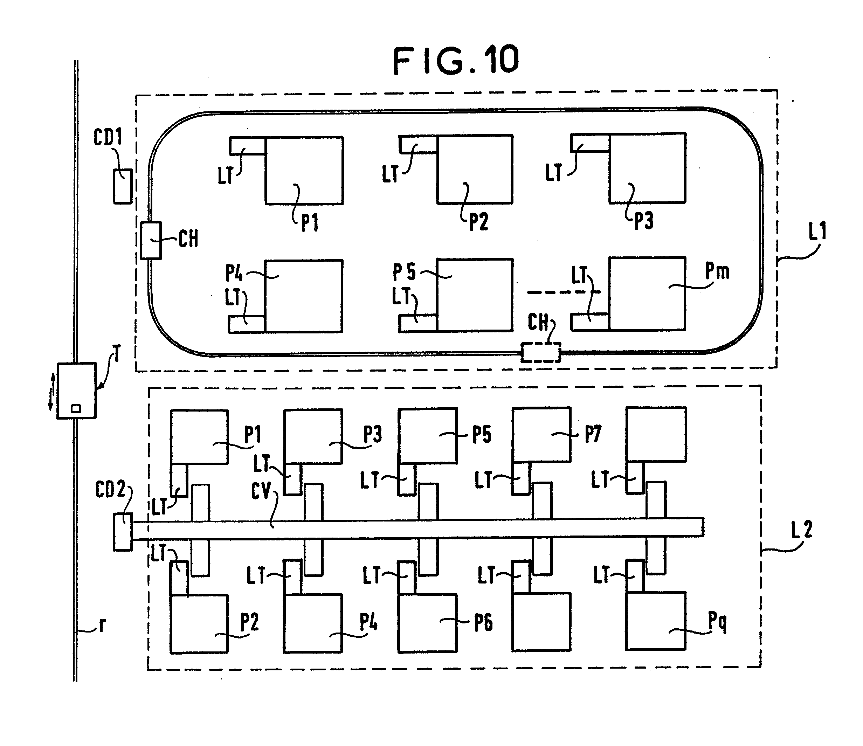

La figure 10 illustre à titre d'exemple, deux types d'îlot L1 et L2, associés aux postes d'entrée/sortie CD1 et CD2. L'îlot L1 comporte un certain nombre de postes de travail P1 à Pm, par exemple des machines automatiques qui sont d'un même type, ou de types différents. Les postes de travail sont approvisionnés en chargeurs par des chariots filoguidés CH, à partir du poste d'entrée/sortie CD1 ; les chariots assurent également l'acheminement des chargeurs d'un poste de travail à un autre, si l'îlot comporte des postes de travail différents correspondant à une gamme d'exécution de travaux ; le chariot ramène les chargeurs, après leur passage sur le, ou les, poste de travail, au poste d'entrée/sortie CD1.

L'îlot L2 comporte un certain nombre de postes de travail P1 à Pq qui sont par exemple des postes manuels, du même type ou de types différents ; le poste d'entrée/sortie CD2 est relié à un convoyeur CV, à double sens de circulation qui achemine les chargeurs vers les postes de travail, ou les ramène au poste d'entrée/sortie.

Dans les deux cas, les postes de travail des îlots L1 et L2 comportent des moyens LT de lecture du code d'identification de chaque chargeur et de transmission vers le calculateur central CC.

Bien entendu les chariots CH, le convoyeur CV, sont commandés par le calculateur central de l'atelier flexible.

D'une manière générale chaque îlot est desservi directement par un transtockeur via le poste d'entrée/sortie qui lui est associé, et c'est à partir de ce poste d'entrée/sortie que le, ou les, postes de travail sont desservis par un moyen de manutention automatique tel que convoyeur, chariots filoguidés, ou par manutention manuelle.

Comme cela a été indiqué ci-dessus, dans l'atelier flexible de l'invention le magasin est le plus souvent situé au milieu de l'atelier ce qui réduit les temps de manutention, donc les en cours entre le magasin et les îlots puisque ceux-ci ont tous un poste d'entrée/sortie à proximité du magasin. Le stockage des chargeurs en hauteur ne nécessite qu'une faible surface au sol, et dans le cas d'un magasin comportant deux transtockeurs en cas de panne d'un transtockeur on peut effectuer les entrées/sorties des chargeurs à l'aide de l'autre transtockeur et acheminer les chargeurs manuellement. D'autre part l'implantation de l'atelier flexible est très souple ; on peut en effet ajouter, déplacer, supprimer, remplacer, arrêter ou mettre en service un poste de travail dans un îlot sans perturber le fonctionnement.

Il est également possible d'ajouter un ou plusieurs îlots sans être obligé d'arrêter le fonctionnement. L'atelier flexible étant piloté par le calculateur central il est possible de modifier l'ordre de fabrication des ensembles en fonction de différents critères d'urgence ; de même il est possible d'utiliser l'atelier flexible pour fabriquer en même temps des ensembles de types différents, les chargeurs étant acheminés vers les îlots correspondants, ou à l'intérieur d'un îlot vers un poste de travail correspondant à l'opération à effectuer. Enfin, une implantation sur plusieurs niveaux est possible ce qui permet une meilleure utilisation d'un bâtiment au moindre coût.

On va décrire à présent le fonctionnement de l'atelier flexible de l'invention dans le cas de la fabrication de cartes de circuits imprimés, chaque carte constituant un ensemble. Dans cet exemple, la fabrication consiste à monter sur un circuit imprimé de dimensions bien définies qui constitue l'élément de base de l'ensemble des composants tels que diodes, résistances, condensateurs, circuits intégrés, transistors, connecteurs, relais, etc, et à effectuer la soudure de ces composants sur le circuit imprimé. Lorsque la carte de circuit imprimé comporte des composants particuliers, tels que des relais par exemple, ceux-ci ne seront montés qu'après soudage des autres composants ; par conséquent en fonction du type de carte de circuit imprimé certaines opérations de montage ne pourront être effectuées qu'après l'opération de soudage/lavage une telle opération étant effectuée par une ligne de soudage/lavage qui constitue par elle-même un îlot, ou un poste de travail de cet îlot s'il comporte un poste de test pour vérification de la carte après soudage. Les postes de travail des îlots sont utilisés pour le montage de différents types de cartes de circuits imprimés dont les composants sont généralement différents. Chaque poste de travail doit donc être approvisionné à la fois en circuits imprimés d'un type donné, et en composants du type prévu pour être monté sur le type de circuit imprimé.

Avant mise en marche de l'atelier flexible le magasin est chargé à partir d'un atelier de préparation, qui ne fait pas partie de l'invention, où sont effectuées les opérations suivantes :

- Préparation des circuits imprimés nus, à savoir :

marquage, masquage, étuvage, etc...

- Préparation des composants pour les postes manuels,

- Préparation des bandes séquencées pour les machines à insertion axiales,

- Mise dans les chargeurs des circuits imprimés nus, et enregistrement par le calculateur central de la correspondance entre les numéros des circuits imprimés et le numéro du chargeur qui les contient.

Les chargeurs sont alors envoyés au magasin par l'intermédiaire d'un convoyeur par exemple. L'atelier de préparation devra bien entendu avoir une avance de quelques heures sur l'atelier flexible de façon à ce que le magasin de l'atelier flexible puisse toujours fournir des chargeurs aux postes de travail.

D'autre part les machines automatiques sont équipées chacune d'un magasin où sont stockés :

- les sticks de boîtiers de circuits intégrés pour les machines à insertion de circuits intégrés,

- les bandes séquencées pour les machines à insertion axiale,

- les bandes de composants radiaux pour les machines à insertion radiale.

L'alimentation des postes de travail manuels en composants peut se faire de différentes façons :

- les composants sont dans le chargeur avec les circuits imprimés,

- les composants sont dans un chargeur différent du chargeur contenant les circuits imprimés : dans ce cas il faut apporter deux chargeurs par poste de travail,

- les composants sont apportés sur le poste de travail manuel par une monitrice, la préparation ayant été faite dans l'atelier de préparation.

Lorsque les cartes de circuits imprimés d'un chargeur sont complétement équipées de leurs composants, donc que leur fabrication est terminée, deux solutions sont possibles :

- après être passé sur le dernier poste de travail, qui est par exemple un poste de test, le chargeur est vidé de ses cartes,

- après être passé sur le dernier poste de travail le chargeur avec ses cartes, est rangé dans un rayonnage ; il n'en sortira que lorsque l'on voudra utiliser les cartes.

Dans les deux cas les chargeurs vides retournent dans un rayonnage par convoyeur, aérien ou au sol par exemple.

Le fonctionnement de l'atelier flexible de l'invention est le suivant, compte tenu que le ou les transtockeurs sont pilotés par le calculateur central CC et que les postes de travail, qu'ils soient automatiques ou manuels, sont reliés au calculateur central, de manière à informer ledit calculateur central de la libération d'un chargeur ; les poste de travail sont reliés au calculateur central soit directement soit par l'intermédiaire d'une console, pour les postes de travail manuels en particulier. La libération d'un chargeur par un poste de travail indique au calculateur central que ledit poste de travail est demandeur. Si dans les îlots les postes de travail sont identiques, un chargeur libéré par un poste de travail, devra retourner au magasin, et un poste demandeur devra être approvisionné par le magasin. Le calculateur central étant informé qu'un poste de travail est demandeur donne l'ordre à l'automate pilotant un transtockeur de sortir d'un rayonnage du magasin un chargeur se trouvant dans l'avéole de coordonnées X, Y, et de rentrer le chargeur libéré dans l'alvéole de coordonnées X', Y'.

Pour acheminer un chargeur à destination d'un poste de travail demandeur deux conditions doivent être remplies :

- il faut que le chargeur soit passé préalablement aux différents postes de travail imposés par le cycle de fabrication,

- il faut que le chargeur soit dans un rayonnage du magasin et non sur un poste de travail.

Ceci implique un retour systématique des chargeurs dans le magasin après passage sur un poste de travail, et l'attribution d'un chargeur à un poste de travail dès que celui-ci libère un chargeur, donc qu'il est demandeur.

Si dans un îlot les postes de travail ne sont pas tous identiques, cet îlot assure un certain nombre d'opérations qui doivent être exécutées selon un certain ordre imposé par le cycle de fabrication, les chargeurs passant d'un poste de travail à un autre selon l'ordre imposé par le cycle de fabrication ; dans ce cas on dira que l'îlot libère un chargeur lorsque le dernier poste de travail libère un chargeur et que l'îlot est demandeur lorsque le premier poste de travail a terminé le chargeur dont il avait la charge. Les deux conditions données ci-dessus sont toujours valables, mais la première condition peut correspondre au passage préalable sur plusieurs postes de travail d'un îlot ou sur plusieurs îlots.

Le choix d'un chargeur dans le magasin, parmi ceux qui répondent aux deux conditions précédentes, pourra alors se faire en prenant en considération les critères suivants :

- en fonction du type de cartes de circuits imprimés dernièrement passées au poste de travail demandeur, ceci pour prendre en compte le fait que ce poste de travail est ou n'est plus encore approvisonné en composants d'un certain type,

- en fonction de la gamme résiduelle des opérations à effectuer sur les cartes du chargeur,

- en fonction du temps passé par le chargeur dans le magasin ; le choix se fera alors sur le chargeur le plus ancien,

- en fonction de l'urgence de fabrication,

- en fonction de la priorité du chargeur, cette priorité étant établie par le système de gestion de la production.

Ces critères sont classiques et utilisés dans tout procédé de fabrication.

Le retour systématique d'un chargeur dans le magasin après passage sur un îlot permet de connaître son état d'avancement par rapport à la gamme des opérations de la fabrication et de connaître à tout moment l'en-cours exact. La connaissance de l'état d'avancement permet de répondre à la première condition énoncée ci-dessus ; la présence des chargeurs dans le magasin permet le choix du chargeur à sortir en fonction des critères indiqués ci-dessus.

On a indiqué ci-dessus les deux conditions à remplir pour acheminer un chargeur vers un poste de travail demandeur, le choix intervenant ensuite en prenant certains critères en considération. Dans le cas d'un ou de plusieurs chargeurs urgents, c'est-à-dire devant impérativement passer sans délai soit à tous les postes de travail, soit à tous les postes de travail correspondant à la gamme résiduelle, il est possible de transférer directement par un transtockeur, un chargeur d'un îlot à un autre sans passer par le magasin, dès lors que ces îlots sont desservis par le même transtockeur.

L'atelier flexible de l'invention autorise la fabrication de différents types d'un ensemble, c'est-à-dire, pour reprendre l'exemple des cartes de circuits imprimés, la fabrication de cartes de même format mais équipées de composants différents, et la fabrication de cartes de formats différents équipées, en partie ou en totalité de composants différents.

A chaque type de carte de circuit imprimé correspond une gamme opératoire, de sorte que certains types de cartes ne nécessitent pas de passer sur certains îlots. Ce problème est aisément résolu par l'atelier flexible de l'invention puisqu'un chargeur, qui ne contient obligatoirement qu'un type de cartes, n'est acheminé que vers les îlots qui correspondent à une, ou plusieurs, opérations de sa gamme opératoire.

D'autre part les opérations sur certains postes de travail peuvent être plus longues que d'autres, de sorte que si les opérations sur le poste précédent sont plus rapides il est nécessaire de stocker les cartes ; avec l'atelier flexible le stockage est assuré puisque les chargeurs sont rangés en magasin après passage sur un îlot. Si les opérations sur un poste de travail sont plus rapides que sur le poste de travail précédent, on peut être amené à doubler ce poste de travail précédent, ce qui peut également conduire à un stockage de cartes de circuits imprimés ; l'atelier flexible permet d'assurer ce stockage. De même en cas de panne d'un îlot ou d'un poste de travail, l'atelier flexible permet d'une part de stocker les chargeurs qui doivent impérativement passer sur cet îlot ou ce poste de travail avant de passer sur un autre îlot ou un autre poste de travail, et d'autre part d'acheminer vers un autre îlot les chargeurs dont le passage sur l'îlot en panne n'est pas impératif, pour les acheminer ensuite vers ledit îlot lorsqu'il est dépanné.

De même s'il est nécessaire, pour des impératifs de fabrication, de changer de type de cartes de circuits imprimés en cours de fabrication, l'atelier flexible permet le stockage des chargeurs dont la fabrication est arrêtée, puis la reprise de la fabrication dès que cela est possible, en prenant en considération d'une part les deux conditions énoncées et principalement la première puisque le calculateur central connaît le dernier îlot ou poste de travail où chaque chargeur est passé, et d'autre part les divers critères mentionnés ci-dessus. De cette manière la gamme opératoire est respectée et la fabrication est reprise normalement.

Comme cela a été indiqué, l'atelier flexible de l'invention peut servir à la fabrication d'ensembles autres que les cartes de circuits imprimés, les postes de travail étant bien évidemment adaptés au type d'ensembles fabriqués.

REVENDICATIONS

1/ Atelier flexible de fabrication d'ensembles mécaniques et/ou électriques, notamment de cartes de circuits imprimés, un ensemble comportant un élément de base et des pièces ou des composants montés sur
ledit élément de base, ledit atelier effectuant des opérations d'usinage et/ou de montage et comportant un magasin où lesdits éléments de
base sont stockés, des postes de travail alimentés en éléments de base
à partir du magasin, et un calculateur central pour piloter le magasin
et l'acheminement des éléments de base vers les postes de travail,
caractérisé par le fait que le magasin comporte au moins un rayonnage (R) ayant deux faces longitudinales dont l'une au moins est
ouverte, et au moins un transtockeur (T), un transtockeur se déplaçant
le long d'une face longitudinale ouverte et comportant des moyens de
pilotage commandés par le calculateur central, que ledit rayonnage (R)
est constituée par des alvéoles (A) disposées en lignes et en
colonnes, que des chargeurs (C) sont rangés dans les alvéoles (A) à
raison d'un chargeur (C) par alvéole chaque chargeur ayant un code
d'identification, que des îlots (L1 à Ln) constitués chacun par au
moins un poste de travail sont disposés en regard d'au moins une
desdites faces longitudinales, chaque îlot étant associé à un poste
d'entrée/sortie (CD1 à CDn) qui reçoivent les chargeurs sortis du
magasin par le transtockeur (T) et destinés à l'îlot, et les chargeurs
libérés par l'îlot pour être rangés par le transtockeur dans le
magasin, que les chargeurs rangés dans les alvéoles sont des chargeurs
contenant chacun au moins un élément de base, lesdits chargeurs attendant d'être sortis pour la première fois du magasin, et des chargeurs
libérés par un îlot quelconque et contenant chacun ledit élément de
base après passage sur ledit îlot quelconque, qu'un transtockeur
comporte des moyens de pilotage commandés par le calcultateur central,
et que les postes de travail des îlots comportent des moyens pour
informer le calculateur central (CC) de la libération d'un
chargeur (C) ledit calculateur central commandant les ehtrées et les
sorties des chargeurs du rayonnage (R) et leur passage d'un îlot à un
autre selon une gamme opératoire.

2/ Atelier flexible selon la revendication 1, caractérisé par le fait que le magasin comporte un rayonnage (R) ouvert sur ses deux faces longitudinales et un transtockeur (T1, T2) en regard de chaque face longitudinale, que tout chargeur du rayonnage R est accessible par les deux transtockeurs T1 et T2, et que les îlots (L1 à Ln) sont situés en regard de chaque face longitudinale, les postes d'entrée/sortie (CD1 à CDi) des chargeurs étant situés du même côté que les îlots (L1 à Li) associés par rapport au transtockeur (T1) desservant lesdits îlots (L1 à Li).

3/ Atelier flexible selon la revendication 1, caractérisé par le fait que le magasin comporte un rayonnage (R) et un transtockeur (T), que les îlots (L1 à Ln) sont situés en regard de chaque face longitudinale, que le transtockeur (T) se déplace entre d'une part une face longitudinale du rayonnage et d'autre part les îlots et les postes d'entrée/sortie qui leurs sont associés, situés en regard de ladite face longitudinale, et que les postes d'entrée/sortie associés aux îlots situés en regard de l'autre face longitudinale du rayonnage (R) sont constitués chacun par une alvéole (A) dudit rayonnage.

4/ Atelier flexible selon la revendication 1, caractérisé par le fait que le magasin comporte deux rayonnages (R1, R2) disposés parallèlement et un transtockeur (T) situé entre les deux rayonnages, que les îlots (L1 à Ln) sont situés en regard d'une face longitudinale de chaque rayonnage opposée à celle le long de laquelle se déplace le transtockeur, et que les postes d'entrée/sortie des îlots sont constitués chacun par une alvéole (A) des deux rayonnages.

5/ Atelier flexible selon la revendication 1, caractérisé par le fait que le magasin comporte deux rayonnages (R1, R2) disposés parallèlement, un premier transtockeur (T1) situé entre les deux rayonnages et un deuxième transtockeur (T2) situé de l'autre côté de l'un des rayonnages par rapport au premier transtockeur (T1), que les îlots sont situés en regard d'une face longitudinale de chaque rayonnage opposée à celle le long de laquelle se déplace le premier transtockeur (T1), que le deuxième transtockeur (T2) se déplace entre d'une part une face longitudinale de l'un des rayonnages et d'autre part les îlots et les postes d'entrée/sortie qui leurs sont associés, situés en regard de ladite face longitudinale, et que les postes d'entrée/sortie associés aux îlots situés en regard de la face longitudinale de l'autre rayonnage sont constitués chacun par une alvéole (A) dudit rayonnage.

6/ Atelier flexible selon la revendication 1, caractérisé par le fait que le magasin comporte un premier (R1), un deuxième (R2) et un troisième (R3) rayonnages disposés parallèlement, un premier transtockeur (T1) entre les premier et deuxième rayonnages et un deuxième transtockeur (T2) entre les deuxième et troisième rayonnages, que tout chargeur du rayonnage R2 est accessible par les deux transtockeurs T1 et T2, que les îlots sont disposés en regard des faces longitudinales des premier et troisième rayonnages opposées à celles en regard des transtockeurs, et que les postes d'entrée/sortie des îlots sont constitués chacun par des alvéoles (A) des premier et troisième rayonnages.

7/ Atelier flexible selon l'une des revendications 1, 2, 3, 4, 5 et 6, caractérisé par le fait qu'il comporte au moins deux niveaux ayant chacun des îlots et que le magasin est commun aux niveaux.

8/ Atelier flexible selon la revendication 1, caractérisé par le fait que les postes de travail d'un îlot sont reliés par un convoyeur (CV) à double sens de circulation au poste d'entrée/sortie des chargeurs associés à l'îlot.

9/ Atelier flexible selon la revendication 1, caractérisé par le fait que les postes de travail d'un îlot sont reliés par des chariots filoguidés (CH) au poste d'entrée/sortie des chargeurs associés à l'îlot.

10/ Atelier flexible selon la revendication 1, caractérisé par le fait que chaque poste de travail d'un îlot est muni d'un lecteur de code pour lire le code des chargeurs et des moyens de transmission dudit code au calculateur central (CC).

# FIG.1

# FIG.2

# FIG.3

# FIG.4

0174545

FIG.5

5/9

0174545

FIG.6

0174545

FIG. 7

FIG.8

FIG.9

0174545

FIG.10

**0174545**

Numero de la demande

**RAPPORT DE RECHERCHE EUROPEENNE**

Office européen
des brevets

EP 85 11 0707

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| A | ELECTRONICS INTERNATIONAL, vol. 57, no. 1, janvier 1984, pages 171-174, New York, US; C.H. MANGIN et al.: "Printed-circuit-board assembly picks up on automation" * Page 172, colonne de droite, alinéa 3 - page 173, colonne de gauche, alinéa 3 * | 1 | H 05 K 13/04 H 05 K 13/08 |
| A | BE-A- 569 903 (BELL TELEPHONE) * Page 4, lignes 19-50 * | 1,10 | |
| A | GB-A- 780 921 (G.E.) | | |
| A | FR-A-2 198 353 (USM) | | |

DOMAINES TECHNIQUES RECHERCHES (Int. Cl 4)

H 05 K 13/00

Le présent rapport de recherche a été établi pour toutes les revendications

| Lieu de la recherche | Date d'achèvement de la recherche | Examinateur |
|---|---|---|
| LA HAYE | 16-12-1985 | TIELEMANS H.L.A. |